# EUROPÄISCHE PATENTANMELDUNG

(11) **EP 4 362 097 A2**
(43) Veröffentlichungstag der Anmeldung: **01.05.2024**
(21) Anmeldenummer: 23020471.1
(22) Anmeldetag: 13.10.2023
(51) Int. Cl.: H01L 27/144

(54) **VORRICHTUNG UND VERFAHREN ZUR SUBSTRATSTROMBEGRENZUNG**

(30) Priorität: 28.10.2022 DE 102022128709
(71) Anmelder: Elmos Semiconductor SE, 44227 Dortmund (DE)
(72) Erfinder: Rotter, Thomas, 91077 Neunkirchen am Brand (DE); Kimmel, Nils Johannes, 44575 Castrop-Rauxel (DE)

(57) **Zusammenfassung**

Die Erfindung betrifft ein Verfahren zur Herstellung einer integrierten Schaltung (120, 140) innerhalb einer BCD-Technologie (100) zur Begrenzung eines Substratstroms und/oder zur Vergrößerung einer effektiv wirksamen Nachweistiefe bei einer Absorption von Photonen (300) in die integrierte Schaltung (140). Das Verfahren umfasst ein Einbringen eines hoch dotierten Zusatzbereichs (117) von einem ersten Leitungstyp auf ein niedrig dotiertes Substrat (111) von dem ersten Leitungstyp; ein Einbringen von hoch dotierten ersten Bereichen (112) des ersten Leitungstyps in vorbestimmten ersten Gebieten, wobei die ersten Bereiche (112) einen Mindestabstand zu dem Zusatzbereich (117) aufweisen; ein Einbringen von hoch dotierten zweiten Bereichen (113) eines zweiten Leitungstyps in vorbestimmten zweiten Gebieten, wobei die zweiten Bereiche (113) den Mindestabstand zu dem Zusatzbereich (117) aufweisen; ein Aufbringen einer EPI-Schicht (115) vom ersten Leitungstyp oder vom zweiten Leitungstyp; und eine Prozessierung der integrierten Schaltung (120, 140) auf einer Oberseite (130) der BCD-Technologie (100).

Weiter betrifft die Erfindung eine Integrierte Schaltung (120, 140) zur Begrenzung eines Substratstroms und/oder zur Vergrößerung einer effektiv wirksamen Nachweistiefe bei einer Absorption von Photonen (300) in die integrierten Schaltung (120, 140) in einer BCD-Technologie (100), welche BCD-Technologie (100) einen Substrataufbau (110) aufweist, welcher Substrataufbau (110) ein niedrig dotiertes Substrat (111) von einem ersten Leitungstyp und einen hoch dotierten Zusatzbereich (117) vom ersten Leitungstyp umfasst.

## Beschreibung

Die Erfindung betrifft ein Verfahren zur Herstellung einer integrierten Schaltung innerhalb einer BCD-Technologie zur Begrenzung eines Substratstroms, d.h. mit deutlich unterdrückter Ausprägung eines Stroms von Minoritätsladungsträgern über ein oberflächenfernes Teilgebiet eines Substrats der integrierten Schaltung und/oder zur Vergrößerung einer effektiv wirksamen Nachweistiefe bei einer Absorption von Photonen in der integrierten Schaltung.

Weiter betrifft die Erfindung eine integrierte Schaltung zur Begrenzung eines Substratstroms und/oder zur Vergrößerung einer effektiv wirksamen Nachweistiefe bei Absorption von Photonen in der integrierten Schaltung.

In verschiedenen BCD-Technologien werden monolithisch integrierte Schaltungen dargestellt, welche Bipolartransistoren, gewöhnliche CMOS-Transistoren, sowie auch sog. DMOS-Transistoren umfassen können. Anwendungen für in BCD-Technologie realisierte Schaltungen sind beispielsweise DC/DC-Wandler, Motortreiber und andere hochgradig integrierte leistungselektronische Schaltungen (smart power).

Ein Träger-Substrat einer integrierten Schaltung der BCD-Technologie ist hierbei normalerweise schwach dotiert und umfasst eine ebenfalls schwach dotierte, epitaktisch aufgewachsene Schicht. Auf Grund der schwachen Dotierung können in das Substrat injizierte Minoritätsladungsträger nur mit einer vergleichsweise sehr geringen zeitlichen Rate rekombinieren und haben folglich eine hohe Lebensdauer und damit auch eine hohe Diffusionslänge im Substrat. In Folge dessen kommt es zu Strömen im Substrat, wodurch auch räumlich entfernte Bereiche einer integrierten Schaltung ungewollt elektrisch leitend miteinander verbunden werden können. Auf Grund von Substratstrom-Injektion kann es daher zu unerwünschten, parasitären Wechselwirkungen zwischen funktional und räumlich getrennten Schaltungsbereichen der integrierten Schaltung kommen.

Eine Möglichkeit diese Substratströme zu begrenzen ist, statt der üblicherweise verwendeten Junction-Isolation eine dielektrische Isolation in Form von tiefen Trenchen (DTI) oder durch Verwendung von sog. SOI-Material zu verwenden, um so die unerwünschten Ladungsträgerströme zu unterdrücken. Diese Methoden sind aber entweder komplex und/oder verteuern den Prozess.

Eine andere Möglichkeit diese Substratströme zu begrenzen ist es, die Substratdicke der integrierten Schaltung erheblich zu verringern. Dies hat jedoch den Nachteil, dass die mechanische Handhabung kompliziert wird und auch die thermischen Verhältnisse sich sehr stark verändern. Das Trägersubstrat, meist Silizium, ist in der Regel ein guter Wärmeleiter und durch das Volumen bzw. die Masse auch ein großes Wärmereservoir.

Ein weiterer Ansatz die elektrische Wechselwirkung von Bauelementen und/oder Schaltungsteilen auf Grund von Substratströmen zu vermeiden, ist, die räumlichen Abstände noch weiter zu vergrößern. Dies ist jedoch aus Kostengründen nicht praktikabel.

Eine weitere Methode, um derartige parasitäre Substratströme zu unterbinden ist die Verwendung eines hochdotierten Substrats anstelle eines niedrigdotierten Substrats, wie beispielsweise offenbart von P. Bucella et. al in "Parasitic Substrate Coupling in High Voltage Integrated Circuits", Springer Verlag, S.14-15 und S.82 (2018), https://doi.org/10.1007/978-3-319-74382-0.

Das stark dotierte Substrat lässt die Ladungsträger eines auftretenden Substratstroms schnell rekombinieren, sodass die Reichweite der Ladungsträger sehr stark reduziert wird.

Eine Bereitstellung hochdotierter Substrate für BCD-Technologien, in denen es zu parasitären Substratströmen kommen kann, führt jedoch zu einem hohen logistischen Aufwand, da für die Produktion von BCD-Technologien im Allgemeinen niedrig dotierte Substrate verwendet werden. Zudem ist durch die Verwendung eines anderen Substrats meist auch eine vollständige, oder zumindest teilweise Neu-Qualifikation des Prozesses erforderlich.

Aufgabe der vorliegenden Erfindung ist es demnach eine Lösung für eine verbesserte Realisierung einer integrierten Schaltung innerhalb einer BCD-Technologie bereitzustellen, welches einen Substratstrom begrenzt, wobei die Lösung kostengünstig sein soll und wobei die Lösung keine großen technischen Änderungen eines standardmäßigen Herstellungsverfahrens, sowie keinen erhöhten logistischen Aufwand in der Produktion bedeuten soll.

Zur Lösung der Aufgabe wird ein Verfahren, sowie eine Vorrichtung gemäß den unabhängigen Ansprüchen vorgeschlagen.

Weitere vorteilhafte Ausgestaltungen der Erfindung sind den abhängigen Ansprüchen, der Beschreibung, sowie den Figuren zu entnehmen.

Die vorgeschlagene Lösung sieht ein Verfahren vor zur Herstellung einer integrierten Schaltung in einer BCD-Technologie zur Begrenzung eines Substratstroms und/oder zur Vergrößerung einer effektiv wirksamen Nachweistiefe bei einer Absorption von Photonen in die integrierte Schaltung, welches Verfahren die folgenden Schritte umfasst:
i. Einbringen eines hoch dotierten Zusatzbereichs von einem ersten Leitungstyp auf ein niedrig dotiertes Substrat von dem ersten Leitungstyp;
ii. Einbringen von hoch dotierten ersten Bereichen des ersten Leitungstyps in vorbestimmten ersten Gebieten, wobei die ersten Bereiche einen Mindestabstand zu dem Zusatzbereich aufweisen;
iii. Einbringen von hoch dotierten zweiten Bereichen eines zweiten Leitungstyps in vorbestimmten zweiten Gebieten, wobei die zweiten Bereiche den Mindestabstand zu dem Zusatzbereich aufweisen;
iv. Aufbringen einer EPI-Schicht vom ersten Leitungstyp oder vom zweiten Leitungstyp; und
v. Prozessierung der integrierten Schaltung auf einer Oberseite der BCD-Technologie.

Insbesondere wird die integrierte Schaltung mittels Kontakten an der Oberseite der BCD-Technologie elektrisch kontaktiert.

Insbesondere werden Kontaktbereiche der Kontakte durch Isolationsgebiete voneinander elektrisch isoliert.

In einer ersten Ausgestaltung des Verfahrens wird im Verfahrensschritt i. der hoch dotierte Zusatzbereich mittels Hochenergie-Implantation in das niedrig dotierte Substrat implantiert, sodass der Zusatzbereich derart in das Substrat eingebettet wird, dass die anschließend eingebrachten ersten Bereiche und zweiten Bereiche den Mindestabstand zu dem Zusatzbereich aufweisen.

Insbesondere entspricht eine Einschusstiefe des Zusatzbereichs in dem Substrat mindestens dem Mindestabstand.

Insbesondere wird der Zusatzbereich durch die Hochenergie-Implantation in das Substrat versenkt.

Insbesondere wird der Zusatzbereich derart von der Oberseite des Substrats in das Substrat versenkt, dass ein Substratteilbereich des Substrats oberhalb des Zusatzbereichs eine Dicke aufweist, welche wenigstens dem Mindestabstand entspricht.

Insbesondere weist der in das Substrat implantierte Zusatzbereich wenigstens den Mindestabstand zu einer Oberseite des Substrats auf, auf welche die ersten Bereiche und die zweiten Bereiche eingebracht werden.

Insbesondere entspricht der Mindestabstand einem Wert von wenigstens 1µm. Insbesondere entspricht der Mindestabstand einem Wert von ca. 5µm.

Insbesondere wird für die Hochenergie-Implantation des Zusatzbereichs in das Substrat eine Energie im MeV-Bereich verwendet. Insbesondere wird für die Hochenergie-Implantation des Zusatzbereichs in das Substrat eine Energie von etwa 1 bis 10MeV oder sogar noch höher verwendet.

Insbesondere kann die (Hochenergie-)Implantation des Zusatzbereichs in das Substrat sogar ohne lithographische Maske, d.h. ganzflächig, eingebracht werden. Dies kann die Prozessführung erheblich vereinfachen.

In einer, zu der ersten Ausgestaltung alternativen, zweiten Ausgestaltung wird im Verfahrensschritt i. der Zusatzbereich mittels Lithographie auf das Substrat eingebracht.

Insbesondere erstreckt sich der Zusatzbereich über eine Fläche auf dem Substrat, welche wenigstens einer Projektionsfläche der vorbestimmten Gebiete für die ersten Bereiche und für die zweiten Bereiche entspricht.

Insbesondere erstreckt sich der Zusatzbereich über die gesamte Oberfläche des Substrats der integrierten Schaltung, auf welches Substrat der Zusatzbereich eingebracht wird. In diesem Fall wird für den Prozessschritt des Einbringens des Zusatzbereichs keine Maske benötigt.

In einer Ausgestaltung des Verfahrens wird auf den im Verfahrensschritt i. eingebrachten Zusatzbereich eine niedrig dotierte erste EPI-Schicht vom ersten Leitungstyp oder vom zweiten Leitungstyp mittels Epitaxie aufgebracht.

Insbesondere wird die niedrig dotierte erste EPI-Schicht auf die Oberfläche des Substrats, in welches Substrat der Zusatzbereich implantiert ist, aufgebracht.

Insbesondere wird die niedrig dotierte erste EPI-Schicht auf den auf das Substrat eingebrachten Zusatzbereich aufgebracht.

Insbesondere weist die erste EPI-Schicht eine Dicke auf, welche mindestens dem Mindestabstand entspricht.

In einer Ausgestaltung des Verfahrens werden die im Verfahrensschritt ii. eingebrachten hoch dotierten ersten Bereiche in vorbestimmten ersten Gebieten oder auch ganzflächig eingebracht, wobei die ersten Bereiche
- auf das Substrat eingebracht werden, wenn der Zusatzbereich in dem Substrat implantiert ist, oder
- auf die erste EPI-Schicht eingebracht werden.

In einer Ausgestaltung des Verfahrens werden die im Verfahrensschritt iii. eingebrachten hoch dotierten zweiten Bereiche in vorbestimmten zweiten Gebieten eingebracht, wobei die zweiten Bereiche
- auf das Substrat eingebracht werden, wenn der Zusatzbereich in dem Substrat implantiert ist, oder
- auf die erste EPI-Schicht eingebracht.

Insbesondere werden die ersten Bereiche und/oder die zweiten Bereiche mittels Lithographie auf das Substrat oder die erste EPI-Schicht eingebracht.

Insbesondere werden die ersten Bereiche und/oder die zweiten Bereiche mittels Implantation auf das Substrat oder die erste EPI-Schicht eingebracht.

Insbesondere weisen die ersten Bereiche und die zweiten Bereiche wenigstens den Mindestabstand zu dem Zusatzbereich auf.

Insbesondere weisen die ersten Bereiche und die zweiten Bereiche in senkrechter Richtung wenigstens den Mindestabstand zu dem Zusatzbereich auf.

Insbesondere wird im Verfahrensschritt iv. eine zweite EPI-Schicht vom ersten Leitungstyp oder vom zweiten Leitungstyp mittels Epitaxie aufgebracht.

Insbesondere wird die zweite EPI-Schicht auf die ersten Bereiche und auf die zweiten Bereiche aufgebracht.

Weiter sieht die vorgeschlagene Lösung eine integrierte Schaltung in einer BCD-Technologie vor, welche integrierte Schaltung dazu geeignet ist einen Substratstrom zu begrenzen und/oder eine effektiv wirksame Nachweistiefe bei einer Absorption von Photonen in die integrierte Schaltung zu vergrößern.

Insbesondere weist die BCD-Technologie einen Substrataufbau auf.

Insbesondere weist die BCD-Technologie einen inhomogenen Substrataufbau auf.

Insbesondere umfasst der Substrataufbau ein niedrig dotiertes Substrat von einem ersten Leitungstyp und einen hoch dotierten Zusatzbereich von dem ersten Leitungstyp.

Insbesondere weist das niedrig dotierte Substrat einen spezifischen Widerstand von etwa 10-40Ω*cm auf.

Insbesondere weist der hochdotierte Zusatzbereich einen spezifischen Widerstand auf, welcher um einen Faktor 5-1000 kleiner ist als der spezifische Widerstand des Substrats.

Insbesondere weist der hoch dotierte Zusatzbereich einen spezifischen Widerstand von etwa 0,01-20Ω*cm auf.

Insbesondere weist der hoch dotierte Zusatzbereich einen spezifischen Widerstand von etwa 0,05-1,5Ω*cm auf.

In einer Ausgestaltung ist der Zusatzbereich in das Substrat implantiert.

Insbesondere ist der Zusatzbereich derart von einer Oberseite des Substrats in das Substrat implantiert, dass ein Abstand zwischen der Oberseite des Substrats zu dem in dem Substrat implantierten Zusatzbereich mindestens einem Mindestabstand entspricht.

In einer Ausgestaltung umfasst der Substrataufbau weiter eine niedrig dotierte erste EPI-Schicht.

Insbesondere ist die erste EPI-Schicht vom ersten Leitungstyp oder vom zweiten Leitungstyp.

Insbesondere ist die erste EPI-Schicht auf dem Substrat angeordnet, in welchem Substrat der Zusatzbereich implantiert ist.

Insbesondere ist die erste EPI-Schicht auf dem Zusatzbereich angeordnet.

Insbesondere weist die erste EPI-Schicht eine Dicke auf, welche mindestens dem Mindestabstand entspricht.

Insbesondere weist die niedrig dotierte erste EPI-Schicht einen spezifischen Widerstand von etwa 1-40Ω*cm auf.

In einer Ausgestaltung umfasst die BCD-Technologie hoch dotierte erste Bereiche vom ersten Leitungstyp und hoch dotierte zweite Bereiche vom zweiten Leitungstyp.

Insbesondere sind die ersten Bereiche und die zweiten Bereiche auf dem Substrataufbau angeordnet. Insbesondere weisen die ersten Bereiche und die zweiten Bereiche jeweils mindestens den Mindestabstand zu dem Zusatzbereich auf.

In einer Ausgestaltung umfasst die BCD-Technologie eine niedrig dotierte zweite EPI-Schicht.

Insbesondere ist die zweite EPI-Schicht vom ersten Leitungstyp oder vom zweiten Leitungstyp.

Insbesondere weist die niedrig dotierte zweite EPI-Schicht einen spezifischen Widerstand von etwa 1-40Ω*cm auf.

In einer Ausgestaltung ist an einer Oberseite der BCD-Technologie die integrierte Schaltung prozessiert.

Insbesondere erstreckt sich die integrierte Schaltung von der Oberseite der BCD-Technologie in die zweite EPI-Schicht.

In einer Ausgestaltung umfasst die integrierte Schaltung eine CMOS-Struktur.

In einer Ausgestaltung umfasst die integrierte Schaltung einen Photodetektor, insbesondere eine SPAD-Struktur.

In einer Ausgestaltung ist der hoch dotierte Zusatzbereich dazu eingerichtet einen Substratstrom in der integrierten Schaltung zu begrenzen.

In einer Ausgestaltung ist der hoch dotierte Zusatzbereich dazu eingerichtet eine effektive Nachweistiefe bei einer Absorption von Photonen in die integrierte Schaltung zu vergrößern.

In einer Ausgestaltung entspricht der Mindestabstand einem Wert von wenigstens 1µm. Insbesondere entspricht der Mindestabstand einem Wert von wenigstens 5µm.

In einer Ausgestaltung weist die erste EPI-Schicht eine Dicke von 1-20µm auf.

Insbesondere weist die erste EPI-Schicht eine Dicke von 5-15µm auf.

In einer Ausgestaltung ist der erste Leitungstyp der p-Leitungstyp und der zweite Leitungstyp der n-Leitungstyp.

In einer Ausgestaltung ist der erste Leitungstyp der n-Leitungstyp und der zweite Leitungstyp der p-Leitungstyp.

Der hoch dotierte Zusatzbereich des ersten Leitungstyps bildet gemeinsam mit dem hochdotierten ersten Bereich des ersten Leitungstyps eine Potentialbarriere in dem schwach dotierten Substratteilbereich des Substrats oberhalb des Zusatzbereichs, wenn der Zusatzbereich in dem Substrat implantiert ist, und/oder in der schwach dotierten ersten EPI-Schicht, welche auf dem Zusatzbereich bzw. auf das Substrat, in das der Zusatzbereich implantiert ist, angeordnet ist.

Diese Potentialbarriere verhindert weitestgehend eine Diffusion von Minoritätsladungsträger durch den Substrataufbau von einem ersten zweiten Bereich des zweiten Leitungstyps zu einem zweiten zweiten Bereich des zweiten Leitungstyps der BCD-Technologie, in die die integrierte Schaltung prozessiert ist. Insbesondere wird ein sehr hoher Anteil der Minoritätsladungsträger daran gehindert von dem ersten zweiten Bereich zu dem zweiten zweiten Bereich durch den Substrataufbau zu diffundieren.

Bei einer Diffusion der Minoritätsladungsträger durch den Zusatzbereich wird eine Rekombination der Minoritätsladungsträger beschleunigt.

In dem Fall, dass Minoritätsladungsträger durch den Zusatzbereich bis in das darunterliegende schwach dotierte Substrat gelangen, werden die Minoritätsladungsträger aufgrund der durch den Zusatzbereich gebildeten elektrischen Barriere vermehrt nicht zurück durch den Zusatzbereich diffundieren. Insbesondere werden die Minoritätsladungsträger, welche durch den Zusatzbereich diffundiert sind, von dem Zusatzbereich abgestoßen. Die Minoritätsladungsträger passieren den Zusatzbereich von einem Gebiet einer höheren Ladungskonzentration hin zu einem Gebiet niedrigerer Ladungskonzentration, welches durch das Substrat unterhalb des Zusatzbereichs bereitgestellt wird. Die Minoritätsladungsträger werden somit den Zusatzbereich nur in eine Richtung passieren.

Der Zusatzbereich wirkt somit wie eine semipermeable Schicht für die Minoritätsladungsträger. Durch das Verhindern, dass Minoritätsladungsträger vom Substrat unterhalb des Zusatzbereichs zurück in einen Substratteilbereich des Substrats oberhalb des Zusatzbereichs bzw. in die erste EPI-Schicht gelangen können, werden zusätzlich parasitäre Wechselwirkungen zwischen funktional und räumlich getrennten Schaltungsbereichen der integrierten Schaltung unterbunden.

Photonen, welche von der Oberseite in das Halbleitermaterial eindringen, werden dort innerhalb einer mittleren Eindringtiefe absorbiert. Diese ist z.B. für das Halbleitermaterial Silizium nicht einheitlich und kann für den nahen Infrarotbereich auch mehrere Mikrometer im ein- bis zweistelligen Bereich betragen. Die absorbierten Photonen generieren Elektron-Loch Paare, welche durch Anwesenheit eines elektrischen Feldes schnell und sicher getrennt werden können. Im Fall des oben beschriebenen Substrataufbaus mit einem weiter im Innern des Substrats liegenden Zusatzbereich kann auch die wirksame Absorptionslänge gegenüber der Verwendung eines gewöhnlichen BCD-Substrataufbaus verlängert werden, wenn ein zusätzlicher Absorptionsbereich bis in den tiefer liegenden Zusatzbereich ausgenutzt wird, was die effektiv wirksame Nachweistiefe bei einer Absorption von Photonen in der integrierten Schaltung vergrößert.

Besonders vorteilhaft an dem erfindungsgemäßen Verfahren ist, dass sich das erfindungsgemäße Verfahren lediglich darin von einem konventionellen Herstellungsverfahren für integrierte Schaltungen in der BCD-Technologie unterscheidet, dass zusätzlich der Zusatzbereich auf das Substrat eingebracht wird und ggf. eine erste EPI-Schicht auf den Zusatzbereich bzw. auf das Substrat aufgebracht wird. Die übrigen Verfahrensschritte zur Herstellung der integrierten Schaltung in der BCD-Technologie bleiben identisch.

Das Einbringen des Zusatzbereichs bedeutet somit keine große Änderung eines konventionellen Herstellungsverfahrens.

Weiter wird für die erfindungsgemäße integrierte Schaltung ein standardmäßiges schwach dotiertes Substrat verwendet, wie es für einen Herstellungsprozess von integrierten Schaltungen üblich ist. Somit wird ein logistischer oder auch Qualifikations-Aufwand, wie er für eine Verwendung eines hochdotierten Substrats gemäß dem Stand der Technik erfolgen würde, vermieden.

Ein weiterer Vorteil dieser Implementierung ergibt sich durch die vergleichsweise niederohmige Verbindung durch den tief vergrabenen Zusatzbereich. Auch vermeintlich getrennte oder nur hochohmig oder gar floatend angeschlossene erste Bereiche des ersten Leitungstyps werden nun deutlich besser als nur über das hochohmige Trägersubstrat miteinander elektrisch verbunden. Dies reduziert ungewollte Spannungsversätze innerhalb dieser elektrischen Substratgebiete und kann so auch z.B. die Gefahr eines Latch-Ups reduzieren.

Weitere vorteilhafte Ausgestaltungen, Merkmale und Funktionen der Erfindung sind in Zusammenhang mit den in den Figuren gezeigten Beispielen erklärt.

Hierbei zeigt:
- Fig. 1: schematische Darstellung eines Substratstroms in einer integrierten Schaltung innerhalb BCD-Technologie gemäß dem Stand der Technik;
- Fig. 2: schematische Darstellung eines Substratstroms in einer integrierten Schaltung innerhalb einer BCD-Technologie mit Substratstrombegrenzung gemäß dem Stand der Technik;
- Fig. 3: schematische Darstellung einer erfindungsgemäßen integrierten Schaltung innerhalb einer BCD-Technologie mit Substratstrombegrenzung;
- Fig. 4: schematische Darstellung eines Substratstroms in einer erfindungsgemäßen integrierten Schaltung innerhalb einer BCD-Technologie mit Substratstrombegrenzung; und
- Fig. 5: schematische Darstellung einer mit dem erfindungsgemäßen Verfahren hergestellten SPAD-Diode.

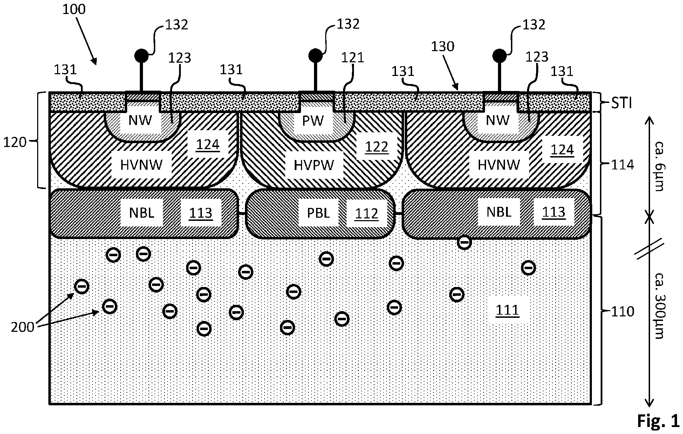

Fig. 1 zeigt eine schematische Darstellung eines Substratstroms in einer integrierten Schaltung innerhalb einer BCD-Technologie 100 gemäß dem Stand der Technik.

Ein Substrataufbau 110 der BCD-Technologie 100 umfasst ein schwach dotiertes Substrat 111 eines ersten Leitungstyps.

Insbesondere weist das schwach dotierte Substrat 111 in der Regel einen spezifischen Widerstand von etwa 10-40Ω*cm auf.

Die Dicke des schwach dotierten Substrats 111 beträgt zu Beginn des Fertigungsprozesses in der Regel etwa 725µm z.B. für die Verwendung eines 8 Zoll Wafermaterials. Nach Durchlauf des Waferprozesses wird der Wafer von der Unterseite des Substrats 111 meist mechanisch gedünnt auf ca. 300µm Restdicke und anschließend die integrierte Schaltung 120 vereinzelt. Die Darstellung und die in Fig. 1 genannte Dicke des Substrats 111 ist also die Substratdicke im Endzustand.

Auf dieses schwach dotierte Substrat 111 werden in vorbestimmten Gebieten hoch dotierte erste Bereiche 112 des ersten Leitungstyps und hoch dotierte zweite Bereiche 113 eines zweiten Leitungstyps angeordnet.

Anschließend erfolgt eine Epitaxie einer schwach dotierten ersten EPI-Schicht 114 vom ersten oder zweiten Leitungstyp.

Die schwach dotierte erste EPI-Schicht 114 weist in der Regel eine Dicke von etwa 2-20µm, typischerweise 6µm auf.

Insbesondere weist die erste EPI-Schicht 114 einen spezifischen Widerstand von 1-40Ω*cm auf.

Der spezifische Widerstand der ersten EPI-Schicht 114 entspricht somit weitestgehend dem spezifischen Widerstand des schwach dotierten Substrats 111.

In die schwach dotierte erste EPI-Schicht 114 ist in dem im Fig. 1 dargestellten Beispiel eine integrierte Schaltung, umfassend eine CMOS-Struktur 120, eingebettet, welche erste Wannen 121 des ersten Leitungstyps, sowie erste Hoch-Volt-Wannen 122 des ersten Leitungstyps und zweite Wannen 123 des zweiten Leitungstyps, sowie zweite Hoch-Volt-Wannen 124 des zweiten Leitungstyps umfasst, welche sich von der Oberseite 130 der BCD-Technologie 100 in die erste EPI-Schicht 114 hinein erstrecken.

Die Bereiche der ersten Wannen 121 und ersten Hoch-Volt-Wannen 122 bzw. zweiten Wannen 123 und zweiten Hoch-Volt-Wannen 124 sind mittels elektrischer Kontakte 132 kontaktiert, wobei die Kontakte 132 durch Isolationsgebiete 131 voneinander elektrisch isoliert sind.

In Fig. 1 ist der durch das schwach dotierte Substrat 111 fließende Substratstrom mittels im Substrat 111 injizierte Minoritätsladungsträger 200 dargestellt.

Aufgrund der niedrigen Dotierung des Substrats 111 rekombinieren in das Substrat 111 injizierte Minoritätsladungsträger nur sehr langsam, wodurch sich eine hohe Lebensdauer und Diffusionslänge der Minoritätsladungsträger 200 im Substrat 111 ergibt. In Folge dessen kann es zu parasitären Wechselwirkungen zwischen funktional und räumlich getrennten Schaltungsbereichen der integrierten Schaltung kommen.

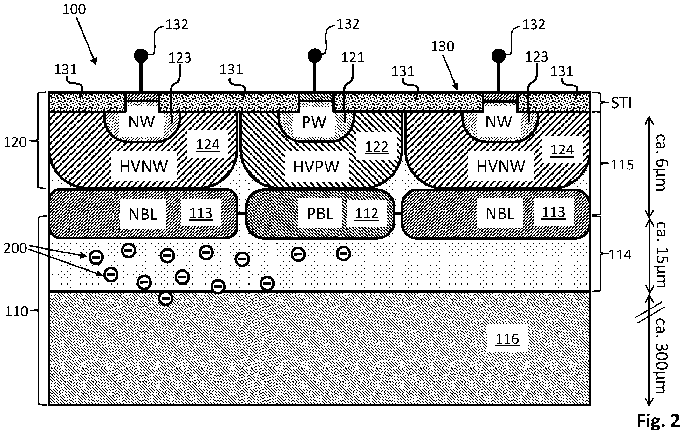

Fig. 2 zeigt eine Integrierte Schaltung umfassend eine CMOS-Struktur 120 in einer BCD-Technologie 100 gemäß dem Stand der Technik, wobei ein Substrataufbau 110 der BCD-Technologie 100 ein hochdotiertes Substrat 116 des ersten Leitungstyps und eine schwach dotierte erste EPI-Schicht 114 aufweist, wobei die erste EPI-Schicht 114 auf das hochdotierte Substrat 116 aufgebracht ist.

Insbesondere weist das hochdotierte Substrat 116 in der Regel einen spezifischen Widerstand von etwa 20mΩ*cm auf.

Die Dicke des hochdotierten Substrats 116 beträgt im Endzustand in der Regel etwa 300µm.

Der spezifische Widerstand der schwach dotierten ersten EPI-Schicht 114 ist um einen Faktor 500 bis 2000 höher als der spezifische Widerstand des hoch dotierten Substrats 116.

Insbesondere weist die erste EPI-Schicht 114 in der Regel eine Dicke von etwa 3-30µm, typischerweise 15µm und einen spezifischen Widerstand von 1-40Ω*cm auf.

Auf die schwach dotierte erste EPI-Schicht 114 werden in vorbestimmten Gebieten hoch dotierte erste Bereiche 112 des ersten Leitungstyps und hoch dotierte zweite Bereiche 113 eines zweiten Leitungstyps angeordnet.

Anschließend erfolgt eine Epitaxie einer schwach dotierten zweiten EPI-Schicht 115 vom ersten Leitungstyp.

Die zweite EPI-Schicht 115 weist in der Regel eine Dicke von etwa 2-20µm, typischerweise 6µm auf. Insbesondere weist die zweite EPI-Schicht 115 einen spezifischen Widerstand von 1-40Ω*cm auf.

Der spezifische Widerstand der schwach dotierten zweiten EPI-Schicht 115 entspricht weitestgehend dem spezifischen Widerstand der schwach dotierten ersten EPI-Schicht 114 des Substrataufbaus 110. In die schwach dotierte zweite EPI-Schicht 115 ist äquivalent zu dem in Fig. 1 dargestellten Beispiel eine integrierte Schaltung, umfassend eine CMOS-Struktur 120, eingebettet.

Die CMOS-Struktur 120 umfasst erste Wannen 121 des ersten Leitungstyps, sowie erste Hoch-Volt-Wannen 122 des ersten Leitungstyps und zweite Wannen 123 des zweiten Leitungstyps, sowie zweite Hoch-Volt-Wannen 124 des zweiten Leitungstyps, welche sich von der Oberseite 130 der BCD-Technologie 100 in die zweite EPI-Schicht 115 hinein erstrecken.

Die CMOS-Struktur 120 ist an der Oberseite 130 der BCD-Technologie 100 mit Kontakten 132 kontaktiert, wobei die Kontaktbereiche voneinander durch Isolationsgebiete 131 voneinander elektrisch isoliert sind.

Ein Substratstrom in der in Fig. 2 dargestellten integrierten Schaltung ist durch Minoritätsladungsträger 200, die durch die erste EPI-Schicht 114 des Substrataufbaus 110 diffundieren, dargestellt.

Durch die Verwendung eines hoch dotierten Substrats 116 wird erreicht, dass die Minoritätsladungsträger 200 eines auftretenden Substratstroms mit sehr kurzen Rekombinationszeiten im hoch dotierten Substrat 116 rekombinieren, bzw. dass zumindest ein Aufenthalt der Minoritätsladungsträger 200 im Substrataufbau 110 in einem Gebiet innerhalb der schwach dotierten ersten EPI-Schicht 114 nahe der Grenzfläche zwischen der ersten EPI-Schicht 114 und des hoch dotierten Substrats 116 beschränkt ist.

Auf diese Weise können parasitäre Wechselwirkungen zwischen funktional und räumlich getrennten Schaltungsbereichen des BCD-Bauteils 100 weitestgehend unterbunden werden.

Nachteilig an der Verwendung eines hoch dotierten Substrats 116 für eine integrierte Schaltung in einer BCD-Technologie 100 ist, dass in der Produktion von integrierten Schaltungen in der Regel schwach dotierte Substrate verwendet werden, und somit für spezielle integrierte Schaltungen, in denen es zu einem Substratstrom, der zu parasitären Wechselwirkungen führt, auftreten kann, ein nicht standardmäßiges Substrat eingesetzt werden muss.

Dies führt zu einem hohen logistischen Aufwand, da für diese integrierte Schaltungen andersartige Substrate bereitgestellt werden müssen, die unter Umständen von anderen Lieferanten bestellt werden müssen.

Zudem ist durch die Verwendung eines anderen Substrats meist auch eine vollständige, oder zumindest teilweise Neu-Qualifikation des Prozesses erforderlich.

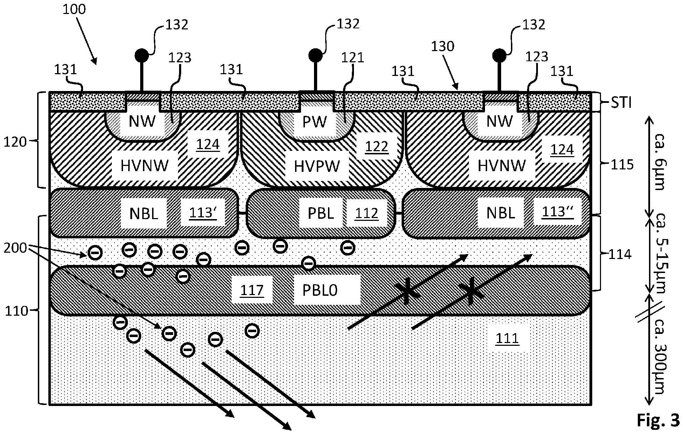

Fig. 3 zeigt ein Ausführungsbeispiel für eine erfindungsgemäße integrierte Schaltung in einer BCD-Technologie 100.

Die in Fig. 3 dargestellte erfindungsgemäße integrierte Schaltung in einer BCD-Technologie 100 umfasst einen Substrataufbau 110, welcher ein standardmäßiges schwach dotiertes Substrat 111 aufweist.

Insbesondere weist das schwach dotierte Substrat einen spezifischen Widerstand von etwa 10-40Ω*cm und einer Dicke von etwa 300µm im Endzustand auf.

Weiter umfasst der Substrataufbau 110 einen hoch dotierten Zusatzbereich 117 des ersten Leitungstyps.

Der spezifische Widerstand des Zusatzbereichs 117 ist um einen Faktor von etwa 5 bis 1000 kleiner als der spezifische Widerstand des Substrats 111.

Insbesondere weist der Zusatzbereich einen spezifischen Widerstand von 0,01-1,5Ω*cm auf.

In dem in Fig. 3 dargestellten Beispiel ist der Zusatzbereich 117 auf das schwach dotierte Substrat 111 eingebracht.

Es ist aber ebenso möglich, dass der Zusatzbereich 117 mittels Hochenergie-Implantation in das Substrat 111 eingebettet wird.

Insbesondere erstreckt sich der Zusatzbereich 117 über die gesamte Fläche des Substrats 111, auf die der Zusatzbereich 117 aufgebracht wird. In diesem Fall kann dies durch eine einfache Implantation ohne Verwendung einer lithographischen Maske erfolgen.

Insbesondere kann der Zusatzbereich oder eine Mehrzahl von Zusatzbereiche nur an bestimmten Teilgebieten des Substrats 111 eingebracht werden. In diesem Fall werden der Zusatzbereich bzw. die Zusatzbereiche in der Regel durch Verwendung lithographischen Photolacks, strukturiert.

In dem in Fig. 3 dargestellten Ausführungsbeispiel umfasst der Substrataufbau 110 eine erste EPI-Schicht 114 vom ersten oder zweiten Leitungstyp.

In einer Variante, in der der Zusatzbereich 117 in das Substrat 111 mittels Hochenergie-Implantation implantiert wird, kann die erste EPI-Schicht 114 weggelassen werden.

Die erste EPI-Schicht 114 weist einen spezifischen Widerstand auf, welcher im Wesentlichen dem spezifischen Widerstand des Substrats 111 entspricht.

Insbesondere weist die erste EPI-Schicht einen spezifischen Widerstad von etwa 1-40Ω*cm auf.

Auf die schwach dotierte erste EPI-Schicht 114 werden in vorbestimmten Gebieten hoch dotierte erste Bereiche 112 des ersten Leitungstyps und hoch dotierte zweite Bereiche 113 eines zweiten Leitungstyps angeordnet.

In einer Ausgestaltung, in der der Zusatzbereich 117 in das Substrat 111 mittels Hochenergie-Implantation eingebettet wird, können die ersten Bereiche 112 und die zweiten Bereiche 113 auf das Substrat 111 angeordnet werden.

Nach dem Anordnen der ersten Bereiche 112 und der zweiten Bereiche 113 erfolgt eine Epitaxie einer schwach dotierten zweiten EPI-Schicht 115 vom ersten Leitungstyp.

Die zweite EPI-Schicht 115 weist in der Regel eine Dicke von etwa 2-20µm, typischerweise 6µm auf. Insbesondere weist die zweite EPI-Schicht 115 einen spezifischen Widerstand auf, welcher weitestgehend dem spezifischen Widerstand der schwach dotierten ersten EPI-Schicht 114, sowie dem spezifischen Widerstand des schwach dotierten Substrats 111 entspricht.

Insbesondere weist die zweite EPI-Schicht 115 einen spezifischen Widerstand von 1-40Ω*cm auf.

In die schwach dotierte zweite EPI-Schicht 115 ist äquivalent wie in den in Fig. 1 und 2 dargestellten Beispielen eine integrierte Schaltung, umfassend eine CMOS-Struktur 120, eingebettet, welche an der Oberseite 130 der BCD-Technologie 100 mit Kontakten 132 kontaktiert ist und wobei die Kontaktbereiche voneinander durch Isolationsgebiete 131 voneinander elektrisch isoliert sind. Insbesondere handelt es sich bei den Isolationsgebieten 131 um eine Shallow Trench Isolation STI, also mit Isolationsmaterial - meist Siliziumoxid - gefüllte flache Gräben.

In Fig. 3 ist ein Substratstrom im Substrataufbau 110 durch Minoritätsladungsträger 200 dargestellt.

Der hoch dotierte Zusatzbereich 117 des ersten Leitungstyps bildet gemeinsam mit dem hochdotierten ersten Bereich 112 des ersten Leitungstyps eine Potentialbarriere in der schwach dotierten ersten EPI-Schicht 114. Diese Potentialbarriere verhindert weitestgehend eine Diffusion von Minoritätsladungsträger 200 von einem ersten zweiten Bereich 113' des zweiten Leitungstyps zu einem zweiten zweiten Bereich 113" des zweiten Leitungstyps durch den Substrataufbau 110. Insbesondere wird ein sehr hoher Anteil der Minoritätsladungsträger 200 daran gehindert von dem ersten zweiten Bereich 113' zu dem zweiten zweiten Bereich des zweiten Leitungstyps 113" durch den Substrataufbau 110 zu diffundieren.

Bei einer Diffusion der Minoritätsladungsträger 200 durch den Zusatzbereich 117 rekombiniert ein Teil der Minoritätsladungsträger 200.

In dem Fall, dass Minoritätsladungsträger 200 durch den Zusatzbereich 117 bis in das schwach dotierte Substrat 111 gelangen, können die Minoritätsladungsträger 200 aufgrund der durch den Zusatzbereich 117 gebildeten elektrischen Barriere nicht zurück durch den Zusatzbereich 117 in die erste EPI-Schicht 114 oder in den oberhalb des Zusatzbereichs 117 liegenden Substratteilbereich des Substrats 111 diffundieren. Insbesondere werden die Minoritätsladungsträger 200, welche von dem Substrat 111 in Richtung Zusatzbereich 117 gelangen, von dem Zusatzbereich 117 abgestoßen. Die Minoritätsladungsträger 200 können somit den Zusatzbereich 117 in der Mehrzahl nur in eine Richtung passieren. Der Zusatzbereich 117 wirkt somit wie eine semipermeable Schicht für die Minoritätsladungsträger 200. Durch das Verhindern, dass Minoritätsladungsträger 200 vom Substrat 111 zurück in die erste EPI-Schicht 114 oder in den oberhalb des Zusatzbereichs 117 liegenden Substratteilbereich des Substrats 111 gelangen können, werden zusätzlich parasitäre Wechselwirkungen zwischen funktional und räumlich getrennten Schaltungsbereichen der integrierten Schaltung in der BCD-Technologie 100 unterbunden.

Damit es zwischen dem Zusatzbereich 117 des ersten Leitungstyps und den zweiten Bereichen 113 des zweiten Leitungstyps nicht zu einem ungewollten p-n-Übergang mit vorzeitigem Durchbruch kommt, muss die erste EPI-Schicht 114 oder der oberhalb des Zusatzbereichs 117 liegende Substratteilbereich, bzw. eine Summe des oberhalb des Zusatzbereichs 117 liegenden Substratteilbereichs und der darauf aufgebrachten ersten EPI-Schicht 114, eine Mindestdicke aufweisen. In den meisten Fällen sollte diese Mindestdicke beträgt ca. 1µm betragen.

Ebenso darf die erste EPI-Schicht 114 oder ein oberhalb des Zusatzgebiets 117 liegender Substratteilbereich, bzw. eine Summe des oberhalb des Zusatzbereichs 117 liegenden Substratteilbereichs und der darauf aufgebrachten ersten EPI-Schicht 114, eine Maximaldicke nicht überschreiten, da andernfalls eine Begrenzung der Minoritätsladungsträger 200 durch eine Potentialbarriere zwischen dem Zusatzbereich 117 und dem ersten Bereich 112 nicht mehr gewährleistet werden kann. Insbesondere beträgt die Maximaldicke etwa 20µm.

Insbesondere weist die erste EPI-Schicht 114 oder der oberhalb des Zusatzbereichs 117 liegende Substratteilbereich des Substrats 111 eine Dicke von 5-15µm auf.

Zur Begrenzung eines Substratstroms kann die integrierte Schaltung in der BCD-Technologie 100 zusätzlich mindestens einen Guard-Ring aufweisen.

Insbesondere ist der mindestens eine Guard-Ring um einen Kontakt 132 an der Oberfläche 130 des BCD-Bauteils 100 angeordnet, an dessen Kontakt 132 eine Störung durch Minoritätsladungsträger 200 hervorgerufene parasitäre Wechselwirkungen auftreten können.

Der mindestens eine Guard-Ring dient so als Senke der Minoritätsladungsträger 200 und vermindert deren Strom in den Bereich der vor Störung zu schützenden Struktur.

Die Verwendung von Guard-Ringen in BCD-Technologien ist beispielsweise offenbart in P. Bucella et. al in "Parasitic Substrate Coupling in High Voltage Integrated Circuits", Springer Verlag, S.78f. und S.121-124 (2018), https://doi.org/10.1007/978-3-319-74382-0.

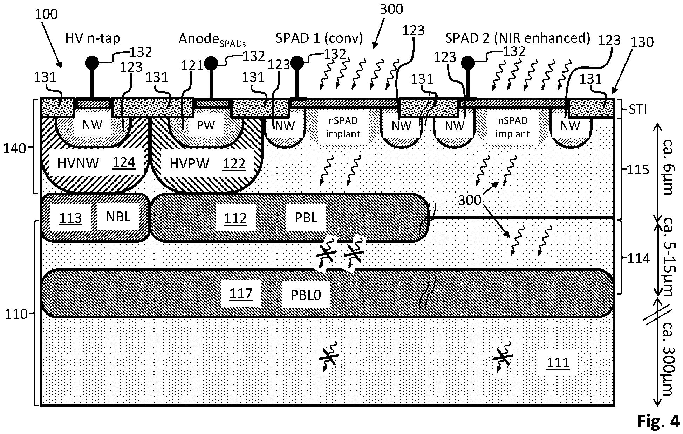

Fig. 4 zeigt eine weitere erfindungsgemäße integrierte Schaltung in einer BCD-Technologie 100, welche einen Substrataufbau 110 umfasst.

Bei der in Fig. 4 dargestellten integrierten Schaltung in der BCD-Technologie 100 handelt es sich um einen Photodetektor 140, insbesondere eine SPAD-Diode bzw. in diesem konkreten Ausführungsbeispiel eine Nah-Infrarot-SPAD-Diode (NIR-SPAD).

Äquivalent zu dem Substrataufbau der in Fig. 3 dargestellten BCD-Technologie mit implantierter CMOS-Struktur, umfasst auch die in Fig. 4 dargestellte BCD-Technologie 100 mit implantierter SPAD-Diode einen Substrataufbau 110, welcher ein schwach dotiertes Substrat 111 des ersten Leitungstyps und einen hoch dotierten Zusatzbereich 117 aufweist.

Bei dem schwach dotierten Substrat 111 handelt es sich um ein für Herstellungsprozesse von integrierten Schaltungen übliches schwach dotiertes Substrat 111 vom ersten Leitungstyp.

Insbesondere weist das Substrat 111 einen spezifischen Widerstand von etwa 10-40Ω*cm auf.

Insbesondere weist das Substrat im Endzustand eine Dicke von etwa 300µm auf.

Das in Fig. 4 dargestellte Ausführungsbeispiel umfasst eine erste EPI-Schicht 114 vom ersten Leitungstyp oder vom zweiten Leitungstyp.

Insbesondere weist die erste EPI-Schicht 114 eine Dicke von 2-20µm, insbesondere von 5-15µm auf.

Insbesondere weist die erste EPI-Schicht 114 einen spezifischen Widerstand von etwa 1-40Ω*cm auf. In einer Ausgestaltung, in der der Zusatzbereich 117 mittels Hochenergie-Implantation in das Substrat 111 eingebettet ist, kann die erste EPI-Schicht 114 weggelassen werden.

Auf das Substrat 111, in welches der Zusatzbereich 117 implantiert ist, bzw. auf die schwach dotierte erste EPI-Schicht 114 werden in vorbestimmten Gebieten hoch dotierte erste Bereiche 112 des ersten Leitungstyps und hoch dotierte zweite Bereiche 113 des zweiten Leitungstyps angeordnet.

Anschließend erfolgt eine Epitaxie einer schwach dotierten zweiten EPI-Schicht 115, welche vom ersten Leitungstyp oder vom zweiten Leitungstyp sein kann.

Insbesondere weist die zweite EPI-Schicht 115 in der Regel eine Dicke von etwa 2-20µm, typischerweise 6µm auf.

Insbesondere weist die zweite EPI-Schicht 115 einen spezifischen Widerstand von etwa 1-40Ω*cm auf.

In die schwach dotierte zweite EPI-Schicht 115 ist eine SPAD-Struktur 140 eingebettet.

Die SPAD-Struktur 140 umfasst erste Wannen 121 des ersten Leitungstyps, sowie erste Hoch-Volt-Wannen 122 des ersten Leitungstyps und zweite Wannen 123 des zweiten Leitungstyps, sowie zweite Hoch-Volt-Wannen 124 des zweiten Leitungstyps, welche in die Oberseite 130 der BCD-Technologie 100 implantiert sind und sich von der Oberseite 130 der BCD-Technologie 100 in die zweite EPI-Schicht 115 hinein erstrecken.

Weiter umfasst die SPAD-Struktur SPAD-Implantate 141, welche sich von der Oberseite 130 der BCD-Technologie 100 in die zweite EPI-Schicht 115 erstrecken.

Die SPAD-Struktur 140 ist an der Oberseite 130 der BCD-Technologie 100 mit Kontakten 132 kontaktiert, wobei die Kontaktbereiche voneinander durch Isolationsgebiete 131 voneinander elektrisch isoliert sind.

Wird eine integrierte Schaltung, umfassend einen Photodetektor, insbesondere mit einer SPAD-Struktur, durch Photonen angeregt, so werden Elektron-Loch-Paare generiert, wobei die angeregten Elektronen zur Kathode und die angeregten Löcher zur Anode primär durch Drift, d.h. durch elektrische Felder, (und vermindert durch Diffusion) gelangen.

In BCD-Technologien mit SPAD-Struktur gemäß dem Stand der Technik ist die effektiv wirksame Nachweistiefe bei Absorption von eindringenden Photonen in die integrierte Schaltung sehr gering. Insbesondere können Elektronen, welche unterhalb des ersten Bereichs im Substratbereich generiert werden, nicht mehr die Kathode an der Oberfläche erreichen. Aufgrund der daraus resultierenden verminderten effektiven Absorptionslänge, ergibt sich ein entsprechend geringer Nutzstrom bzw. kleine Effektivität.

Durch Einbringen eines hoch dotierten Zusatzbereichs 117 des ersten Leitungstyps in eine integrierte Schaltung umfassend eine SPAD-Struktur 140, wie in Fig. 4 dargestellt, kann dieser Nutzstrom deutlich erhöht werden, indem die effektiv wirksame Nachweistiefe von Photonen 300 erhöht wird.

Insbesondere wird der Nutzstrom dadurch erhöht, dass wenn der Zusatzbereich 117 mittels Hochenergie-Implantation in das Substrat 111 eingebettet ist, der oberhalb des Zusatzbereichs 117 liegende Substratteilbereich des Substrats 111 zusätzliche getrennte Ladungsträger bereitstellen kann. Insbesondere wird der Nutzstrom dadurch erhöht, dass die oberhalb des Zusatzbereichs 117 aufgebrachte EPI-Schicht 114 zusätzlich getrennte Ladungsträger bereitstellen kann.

Insbesondere wird der Nutzstrom dadurch erhöht, dass wenn der Zusatzbereich 117 mittels Hochenergie-Implantation in das Substrat 111 eingebettet ist und zusätzlich die erste EPI-Schicht 114 auf das Substrat 111 aufgebracht ist, sowohl der oberhalb des Zusatzbereichs 117 liegende Substratteilbereich des Substrats 111, als auch die auf dem Substrat 111 aufgebrachte erste EPI-Schicht 114 zusätzliche getrennte Ladungsträger bereitstellen kann.

Auf diese Weise wird das Absorptionsvolumen und damit der Nutzstrom deutlich erhöht.

In den in den Fig. 1 bis 4 dargestellten Ausführungsbeispielen entspricht der erste Leitungstyp dem p-Leitungstyp und der zweite Leitungstyp dem n-Leitungstyp.

Die in den Fig. 1 bis 4 dargestellten Ausführungsbeispiele zeigen BCD-Technologien mit durch Epitaxie von der Oberfläche abgesetzten ersten Bereichen vom ersten Leitungstyp und zweiten Bereichen vom zweiten Leitungstyp.

Es ist aber auch möglich, dass die ersten Bereiche und die zweite Bereiche mittels (Hochenergie-) Implantation eingebracht werden.

Es sind auch Ausführungsbeispiele denkbar, welche keine ersten Bereiche vom ersten Leitungstyp und zweite Bereiche vom zweiten Leitungstyp aufweisen.

Eine inverse Ausführung des Ausführungsbeispiels bezüglich des Leitungstyps ist ebenso möglich.

Die Darstellungen sind nicht auf das Halbleitermaterial Silizium beschränkt, sondern kann auf jegliches Halbleitermaterial übertragen werden.

### Bezugszeichenliste

- 100: Integrierte Schaltung innerhalb einer BCD-Technologie
- 110: Substrataufbau
- 111: niedrig dotiertes Substrat
- 112: erster Bereich des ersten Leitungstyps (PBL)
- 113: zweiter Bereich des zweiten Leitungstyps (NBL)
- 114: erste EPI-Schicht
- 115: zweite EPI-Schicht
- 116: hoch dotiertes Substrat
- 117: Zusatzbereich des ersten Leitungstyps (PBL0)

- 120: CMOS-Struktur
- 121: erste Wanne des ersten Leitungstyps (PW)
- 122: erste Hochvolt-Wanne des ersten Leitungstyps (HVPW)
- 123: zweite Wanne des zweiten Leitungstyps (NW)
- 124: zweite Hochvolt-Wanne des zweiten Leitungstyps (HVNW)

- 130: Oberseite des BCD-Bauteils
- 131: Isolationsgebiet (Shallow Trench Isolation STI)
- 132: Kontakt

- 140: Photodetektor, z.B. NIR-SPAD-Struktur
- 141: SPAD-Implantationsgebiet

- 200: Minoritätsladungsträger

## Patentansprüche

1. Verfahren zur Herstellung einer integrierten Schaltung (120, 140) innerhalb einer BCD-Technologie (100) zur Begrenzung eines Substratstroms und/oder zur Vergrößerung einer effektiv wirksamen Nachweistiefe bei einer Absorption von Photonen (300) in die integrierte Schaltung (140),
wobei das Verfahren die folgenden Schritte umfasst:
i. Einbringen eines hoch dotierten Zusatzbereichs (117) von einem ersten Leitungstyp auf ein niedrig dotiertes Substrat (111) von dem ersten Leitungstyp;
ii. Einbringen von hoch dotierten ersten Bereichen (112) des ersten Leitungstyps in vorbestimmten ersten Gebieten,
wobei die ersten Bereiche (112) einen Mindestabstand zu dem Zusatzbereich (117) aufweisen;
iii. Einbringen von hoch dotierten zweiten Bereichen (113) eines zweiten Leitungstyps in vorbestimmten zweiten Gebieten,
wobei die zweiten Bereiche (113) den Mindestabstand zu dem Zusatzbereich (117) aufweisen;
iv. Aufbringen einer EPI-Schicht (115) vom ersten Leitungstyp oder vom zweiten Leitungstyp; und
v. Prozessierung der integrierten Schaltung (120, 140) auf einer Oberseite (130) der BCD-Technologie (100).

2. Verfahren nach Anspruch 1, **dadurch gekennzeichnet,**
**dass** im Verfahrensschritt i. der hoch dotierte Zusatzbereich (117) mittels Hochenergie-Implantation in das niedrig dotierte Substrat (111) implantiert wird, sodass der Zusatzbereich (117) derart in das Substrat (111) eingebettet wird, dass die anschließend eingebrachten ersten Bereiche (112) und zweiten Bereiche (113) den Mindestabstand zu dem Zusatzbereich (117) aufweisen.

3. Verfahren nach Anspruch 1, **dadurch gekennzeichnet,**
**dass** eine niedrig dotierte erste EPI-Schicht (114) vom ersten Leitungstyp oder vom zweiten Leitungstyp mittels Epitaxie auf den im Verfahrensschritt i. eingebrachten Zusatzbereich (117) aufgebracht wird,
wobei die erste EPI-Schicht (114) eine Dicke aufweist, welche mindestens dem Mindestabstand entspricht.

4. Verfahren nach Anspruch 2, **dadurch gekennzeichnet,**
**dass** die niedrig dotierte erste EPI-Schicht (114) vom ersten Leitungstyp oder vom zweiten Leitungstyp mittels Epitaxie auf das Substrat (111) aufgebracht wird, in welchem Substrat (111) der Zusatzbereich (117) implantiert ist.

5. Verfahren nach einem der Ansprüche 2 bis 4, **dadurch gekennzeichnet,**
**dass** die im Verfahrensschritt ii. eingebrachten hoch dotierten ersten Bereiche (112) in vorbestimmten ersten Gebieten
auf das Substrat (111) eingebracht werden, in welchem Substrat (111) der Zusatzbereich (117) implantiert ist, oder
auf die erste EPI-Schicht (114) eingebracht werden.

6. Verfahren nach einem der Ansprüche 2 bis 5, **dadurch gekennzeichnet,**
**dass** die im Verfahrensschritt iii. eingebrachten hoch dotierten zweiten Bereiche (113) in vorbestimmten zweiten Gebieten
auf das Substrat (111) eingebracht werden, in welchem Substrat (111) der Zusatzbereich (117) implantiert ist, oder
auf die erste EPI-Schicht (114) eingebracht werden.

7. Verfahren nach einem der vorstehenden Ansprüche, **dadurch gekennzeichnet,**
**dass** im Verfahrensschritt iv. eine zweite EPI (115) vom ersten Leitungstyp oder vom zweiten Leitungstyp mittels Epitaxie aufgebracht wird, insbesondere wird die zweite EPI-Schicht (115) auf die ersten Bereiche (112) und auf die zweiten Bereiche (113) aufgebracht.

8. Integrierte Schaltung (120, 140) zur Begrenzung eines Substratstroms und/oder zur Vergrößerung einer effektiv wirksamen Nachweistiefe bei einer Absorption von Photonen (300) in die integrierten Schaltung (120, 140) in einer BCD-Technologie (100) gemäß dem Verfahren nach einem der Ansprüche 1 bis 7,
welche BCD-Technologie (100) einen Substrataufbau (110) aufweist,
welcher Substrataufbau (110) ein niedrig dotiertes Substrat (111) von einem ersten Leitungstyp und einen hoch dotierten Zusatzbereich (117) vom ersten Leitungstyp umfasst.

9. Integrierte Schaltung (120, 140) nach Anspruch 8, **dadurch gekennzeichnet,**
**dass** der Zusatzbereich (117) in das Substrat (111) implantiert ist.

10. Integrierte Schaltung (120, 140) nach Anspruch 9, **dadurch gekennzeichnet,**
**dass** der Zusatzbereich (117) derart von einer Oberseite des Substrats (111) in das Substrat (111) implantiert ist, dass ein Abstand zwischen der Oberseite des Substrats (111) zu dem in dem Substrat (111) implantierten Zusatzbereich (117) mindestens einem Mindestabstand entspricht.

11. Integrierte Schaltung (120, 140) nach einem der Ansprüche 8 bis 10, **dadurch**
**gekennzeichnet,**
**dass** der Substrataufbau (110) weiter eine niedrig dotierte erste EPI-Schicht (114) umfasst, welche erste EPI-Schicht (114)
auf dem Substrat (111) angeordnet ist, in welchem Substrat (111) der Zusatzbereich (117) implantiert ist, oder
auf dem Zusatzbereich (117) angeordnet ist,
wobei die erste EPI-Schicht (114) vom ersten Leitungstyp oder vom zweiten Leitungstyp ist.

12. Integrierte Schaltung (120, 140) nach Anspruch 11, **dadurch gekennzeichnet, dass**
die erste EPI-Schicht (114) eine Dicke aufweist, welche mindestens dem Mindestabstand entspricht.

13. Integrierte Schaltung (120, 140) nach einem der Ansprüche 8 bis 12, **dadurch**
**gekennzeichnet,**
**dass** die BCD-Technologie (100) hoch dotierte erste Bereiche (112) vom ersten Leitungstyp und hoch dotierte zweite Bereiche (113) vom zweiten Leitungstyp umfasst,
welche erste Bereiche (112) und zweite Bereiche (113) auf dem Substrataufbau (110) angeordnet sind,
wobei die ersten Bereiche (112) und die zweiten Bereiche (113) jeweils mindestens den Mindestabstand zu dem Zusatzbereich (117) aufweisen.

14. Integrierte Schaltung (120, 140) nach einem der Ansprüche 8 bis 13, **dadurch**
**gekennzeichnet,**
**dass** die BCD-Technologie (100) eine niedrig dotierte zweite EPI-Schicht (115) umfasst,
wobei die zweite EPI-Schicht (115) vom ersten Leitungstyp oder vom zweiten Leitungstyp ist.

15. Integrierte Schaltung (120, 140) nach einem der Ansprüche 8 bis 14, **dadurch**
**gekennzeichnet,**
**dass** an einer Oberseite (130) der BCD-Technologie (100) die integrierte Schaltung (120, 140) prozessiert ist,
welche integrierte Schaltung (120, 140) sich von der Oberseite (130) der BCD-Technologie (100) in die zweite EPI-Schicht (115) erstreckt.

16. Integrierte Schaltung (120, 140) nach einem der Ansprüche 8 bis 15, **dadurch**
**gekennzeichnet,**
**dass** die integrierte Schaltung (120, 140) eine CMOS-Struktur (120) umfasst.

17. Integrierte Schaltung (120, 140) nach einem der Ansprüche 8 bis 16, **dadurch**
**gekennzeichnet,**
**dass** die integrierte Schaltung (120, 140) einen Photodetektor, insbesondere eine SPAD-Struktur (140), umfasst.

18. Integrierte Schaltung (120, 140) nach einem der Ansprüche 8 bis 17, **dadurch**
**gekennzeichnet,**
**dass** der hoch dotierte Zusatzbereich (117) dazu eingerichtet ist einen Substratstrom in der integrierten Schaltung (120, 140) zu begrenzen.

19. Integrierte Schaltung (120, 140) nach einem der Ansprüche 8 bis 18, **dadurch**
**gekennzeichnet,**
**dass** der hoch dotierte Zusatzbereich (117) dazu eingerichtet ist die effektiv wirksame Nachweistiefe bei einer Absorption von Photonen (300) in die integrierte Schaltung (120, 140) zu vergrößern.

20. Integrierte Schaltung (120, 140) nach einem der Ansprüche 10 bis 19, **dadurch**
**gekennzeichnet,**
**dass** der Mindestabstand einem Wert von wenigstens 1µm entspricht, insbesondere einem Wert von wenigstens 5µm entspricht.

21. Integrierte Schaltung (120, 140) nach einem der Ansprüche 11 bis 20, **dadurch**
**gekennzeichnet,**
**dass** die erste EPI-Schicht (114) eine Dicke von 1-20µm, insbesondere eine Dicke von 5-15µm aufweist.

22. Integrierte Schaltung (120, 140) nach einem der Ansprüche 8 bis 21, **dadurch**
**gekennzeichnet,**
**dass** der erste Leitungstyp der p-Leitungstyp ist und der zweite Leitungstyp der n-Leitungstyp ist.

23. Integrierte Schaltung (120, 140) nach einem der Ansprüche 8 bis 21, **dadurch**
**gekennzeichnet,**
**dass** der erste Leitungstyp der n-Leitungstyp ist und der zweite Leitungstyp der p-Leitungstyp ist.
